# EUROPÄISCHE PATENTANMELDUNG

(11) **EP 0 780 980 A2**
(43) Veröffentlichungstag der Anmeldung: **25.06.1997**
(21) Anmeldenummer: 96119573.2
(22) Anmeldetag: 05.12.1996
(51) Int. Cl.: H03K 17/96

(54) **Betätigungsvorrichtung mit zumindest einem optoelektronischen Tastenelement**

(30) Priorität: 18.12.1995 DE 19547300
(71) Anmelder: SIEMENS AKTIENGESELLSCHAFT, 80333 München (DE)
(72) Erfinder: Bomber, Martin, Dipl.-Ing. (FH), 93059 Regensburg (DE); Gay, Thomas, Dipl.-Ing., 89160 Dornstadt (DE); Wagner, Franz-Josef, Dipl.-Ing., 86732 Oettingen (DE)

(57) **Zusammenfassung**

Um trotz toleranz- bzw. alterungsbedingter Streuungen aus den bei Betätigung eines Tastenelementes (T1-T6) empfangenen reflektierten analogen EIN-Signalen bzw. AUS-Signalen ohne Notwendigkeit einer Nachjustierung eine eindeutige Signalerkennung zur Abgabe eines, insbesondere digitalen, entsprechenden EIN/AUS-Stellbefehls der Betätigungsvorrichtung (CO) ableiten zu können, steht die Betätigungsvorrichtung (CO) in EIN/AUS-Schaltabhängigkeit von einer von Null unterschiedlichen Mindestgröße des Verhältnisses zwischen dem EIN-Signalpegel (S1) und dem AUS-Signalpegel (S2).

## Beschreibung

Die Erfindung bezieht sich auf eine Betätigungsvorrichtung mit zumindest einem optoelektronischen Tastenelement gemäß Patentanspruch 1.

Zur Betätigung von Schaltvorgängen ist es in der Industrie oftmals notwendig, den Betätigungszuständen "EIN" bzw. "AUS" eines Tastenelementes mit entsprechenden an der Betätigungsvorrichtung eingangsseitigen, insbesondere analogen, Signalen eindeutige ausgangsseitige, insbesondere digitale, Signale für weitere Schaltbefehle zuordnen zu können. Dazu werden üblicherweise Komparatoren, insbesondere Amplitudenentscheider, herangezogen, welche die analogen Eingangssignale mit einem festen EIN-Schwellwert bzw. einem festen AUS-Schwellwert vergleichen und bei Erreichen dieser Schwellwerte die Zuordnung "EIN" bzw. "AUS" als jeweils entsprechendes digitales Ausgangssignal weitergeben.

Ein bevorzugtes praktisches Anwendungsbeispiel kann in der Bedienung einer elektronischen Kochstellensteuerung gesehen werden, bei der einer Betätigungsvorrichtung mehrere optoelektronische Tastenelemente, insbesondere in Form von berührungsempfindlichen, durch eine schützende Oberfläche geschützten Infrarot-Reflexlichtschranken zugeordnet sind, die bei Vorhandensein einer Mindestreflexion ein EIN-Analogsignal und bei nicht vorhandener Mindestreflexion ein AUS-Analogsignal abgeben, das dann als von der Betätigungsvorrichtung abgegebenes digitales Ausgangssignal "EIN" bzw. Ausgangssignal "AUS" zur Ansteuerung der Kochstellen dient.

Um eine derartige Betätigungsvorrichtung mit einem, insbesondere für ein Serienprodukt, vertretbaren Aufwand fertigen zu können, müssen gewisse Fertigungs- und Einbautoleranzen sowie Streuungen hinsichtlich des Wirkungsgrades eines Senders und der Empfindlichkeit eines Empfängers einer jeweiligen berührungsempfindlichen Reflexlichtschranke in Kauf genommen werden; dies bedingt einen aufwendigen erstmaligen Abgleich vor Inbetriebnahme der Betätigungsvorrichtung, der jedoch aufgrund weiterer Einflüsse, wie Alterung und Temperatur, auch nicht über längere Betriebszeiten gewährleistet werden kann und zusätzlich eine fortlaufende Nachjustierung erfordern würde.

Gemäß Aufgabe vorliegender Erfindung soll daher trotz der bei der Herstellung eines Serienproduktes hinzunehmenden Streuung der eingangsseitigen Signalwerte, insbesondere aufgrund von Bauteil- und Einbautoleranzen, und trotz der über einen längeren Betriebseinsatz hinzunehmenden Änderung der eingangsseitigen Signalwerte, insbesondere aufgrund von Temperatur- und Alterungseinflüssen, auf einfache Weise und ohne Notwendigkeit einer servicebedingten Justierung die sichere Erkennung eines korrespondierenden ausgangsseitigen, insbesondere digitalen, EIN-Signals bzw. AUS-Signals gewährleistet werden können. Die Lösung dieser Aufgabe gelingt durch die Lehre des Patentanspruchs 1; vorteilhafte Ausgestaltungen der Erfindung sind jeweils Gegenstand der Unteransprüche.

Die erfindungsgemäße Betätigungsvorrichtung spricht auf den Rückkopplungs-Grad der vom Sender des optoelektronischen Tastenelementes auf dessen Empfänger reflektierten Strahlen an; da somit bei diesem Prinzip keine festen Schaltschwellen festgelegt werden müssen, sondern stets nur das Verhältnis aus innerer Streureflexion ohne Betätigung einerseits und bei zusätzlicher äußerer Betätigungsreflexion am berührenden Körper, z.B. bei Betätigung des Tastenelementes durch einen auf eine reflektierende Ceranplatte einer zugeordneten Kochstellen-Touchmulde aufgelegten Finger, gebildet wird, ist sowohl ein erstmaliger Initialisierungsabgleich als auch eine spätere betriebsmäßige Nachjustierung nicht mehr notwendig. Eine Alterung bzw. Verschmutzung der Sender- bzw. Empfänger-Bauelemente wirkt sich derart auf die Sender-Empfänger-Strecke aus, daß sowohl die innere Streulichtreflexion als auch die äußere Nutzlichtreflexion im gleichen Verhältnis verändert, insbesondere vermindert werden.

Die Erfindung sowie weitere vorteilhafte Ausgestaltungen der Erfindung werden im folgenden anhand schematisch dargestellter Ausführungsbeispile, insbesondere in Anwendung auf mehrere Tastenelemente in Form von elektronischen Berührungssensoren mit Infrarot-Reflexlichtschranken für eine elektronische Kochstellensteuerung, in der Zeichnung näher beschrieben; darin zeigen:
- FIG 1: den grundsätzlichen Aufbau einer elektronischen Kochstellensteuerung;
- FIG 2: die pulsförmigen analogen EIN/AUS-Betätigungssignale, insbesondere Spannungssignale, eines einzelnen Tastenelementes bei unbetätigter und anschließend bei betätigtem Tastenelement;
- FIG 3: eine einfache Senderbeschaltung einer Infrarot-Reflexlichtschranke;
- FIG 4: eine einfache Empfängerbeschaltung einer elektronischen Reflexlichtschranke;
- FIG 5: ein Beispiel der Toleranzstreubereiche für sechs Tasten einer Kochstellensteuerung.

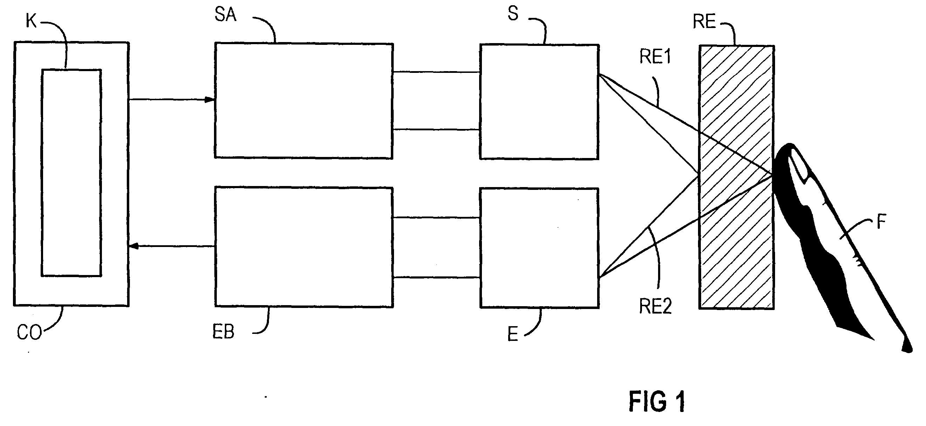

FIG 1 zeigt den Prinzipaufbau einer optoelektronischen Kochstellensteuerung mit einer berührungsempfindlichen Infrarot-Reflexlichtschranke; dazu wird von einem in der Betätigungsvorrichtung CO integrierten elektronischen Controller über eine Sender-Ansteuerung SA ein Sender S, insbesondere eine im Pulsbetrieb arbeitende Infrarotlichtdidode (IR-LED), pulsweise angesteuert. Die Lichtimpulse des Senders S treffen auf eine Glasfläche RE, insbesondere die Ceranfläche, die einer Kochstellen-Touchmulde zugeordnet ist, und werden von dieser bei nicht betätigtem Berührungssensor im wesentlichen nur als Streulichtsignal RE2 aufgrund einer inneren Reflexion zu einem Empfänger E, insbesondere einem Infrarotempfänger, mit einer nachfolgenden Empfänger-Beschaltung EB reflektiert. Erst wenn die äußere Berührungsfläche gezielt, z.B. durch Auflegen eines Betätigungsfingers F, bedeckt und damit das Tastenelement betätigt wird, kommt es zu einem zusätzlichen Betätigungssignal RE1, welches das Streulichtsignal RE2 derart übersteigt, daß in einem Komparator K, der zweckmäßigerweise in der elektronischen Baueinheit der Betätigungsvorrichtung CO integriert ist, aus dem Verhältnis des EIN-Betätigungssignalpegels S1 (RE1+RE2) zu dem AUS-Signalpegel S2 des Streulichtsignals RE2 ein, insbesondere digitale, Signalerkennung zur weiteren Ansteuerung der zugehörigen Kochstelle identifizierbar ist.

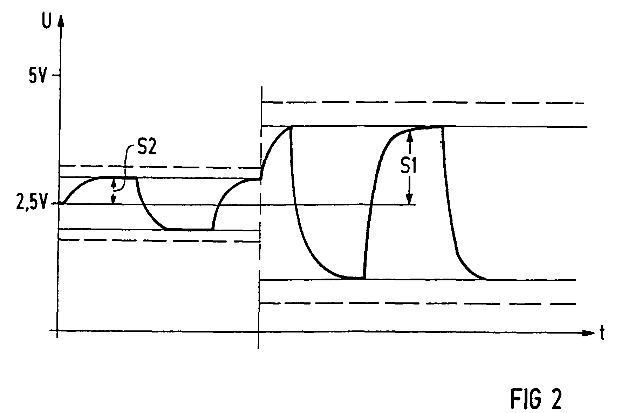

FIG 2 zeigt beispielhaft einen Signalpegel S2 bei nichtbetätigtem Tastenelement T1-T6 bzw. einen Signalpegel S1 im anchließenden Teil bei betätigtem Tastenelement T1-T6, jeweils als Amplitude über einem von Null verschiedenen Spannungsniveau von hier angenommenen 2,5 Volt; dabei zeigen die oberen und unteren, in ausgezogener Kontur gezeichneten Begrenzungslinien der Spannungsamplituden der Impulse eine schlechte Übertragungsstrecke, während die oberhalb bzw. unterhalb in gestrichelter Kontur gezeichneten Begrenzungslinien eine gute Übertragungsstrecke mit entsprechenden äußeren Spannungsamplituden kennzeichnen. Aus dem Verhältnis der Spannungssignalpegel von S1 zu S2 kann dann auf einfache und von Toleranzen unabhängige Weise in der Betätigungsvorrichtung CO eine Auswertung dahingehend erfolgen, ob das Tastenelement gedrückt und somit in EIN-Stellung gebracht oder ungedrückt ist und sich somit in AUS-Stellung befindet, übernommen werden.

Der zu diesem Vergleich in der Betätigungsrichtung CO vorgesehene Komparator K ist zweckmäßigerweise als Meßwertumwandlung zur Abgabe eines entsprechenden digitalen EIN/AUS-Signals bei eingangsseitigen analogen Betätigungssignalen RE1+RE2 bzw. bei eingangsseitigen analogen Streulichtsignalen RE2 ausgebildet; in vorteilhafter Weise ist der Komparator K gleichzeitig derart beschaffen, daß ein z.B. von einer Fremdlichtquelle stammender Gleichlichtanteil ausgefiltert ist.

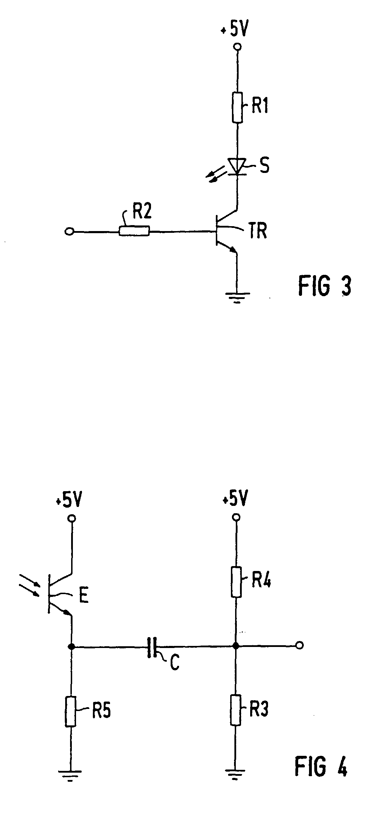

FIG 3 zeigt eine besonders vorteilhafte Schaltung für einen Sender eines Tastenelementes T1-T6 mit einer Infrarot-Reflexlichtschranke; die Sendeeinrichtung besteht im wesentlichen aus einem Sender S in Form einer IR-Sendediode und einer Steuereinheit, in der die Stromstärke für die IR-Sendediode gespeist und über einen mit dieser in Reihe liegenden Widerstand R1 eingestellt werden kann. Ein weiterhin in Reihe der IR-Sendediode S liegender, mit einem Vorwiderstand R2 beschalteter Schalttransistor TR wird von der Betätigungsvorrichtung CO mit einem Rechtecksignal angesteuert, so daß von dem Sender S ein gleichstromfreier pulsweiser Lichtstrahl auf die Glasscheibe RE abgestrahlt wird.

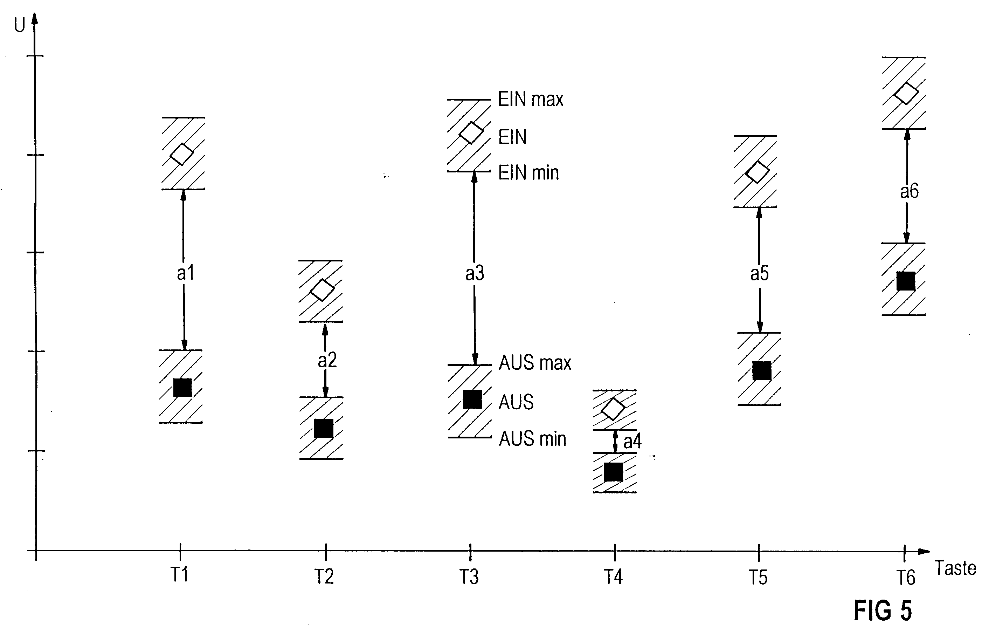

FIG 4 zeigt eine vorteilhafte Empfangseinrichtung zum Empfang des analogen Signals eines reflektierten Streulichtsignals RE2 bzw. zusätzlichen Nutzlichtsignals RE1. Dazu ist als Empfänger E ein IR-Fototransistor mit einem infrarotlichtempfindlichen Widerstand vorgesehen, der je nach Stärke des reflektierten Lichteinfalls das Potential an seinem Emitter zwischen einer Spannung von 0 Volt und etwa einer Maximalspannung von 5 Volt ändert. Über einen in Reihe mit dem Empfänger E liegenden Widerstand R5 läßt sich die Lichtempfindlichkeit des Empfängers E einstellen. Der Emitterausgang und somit die Verbindung zum Widerstand R5 ist über einen Spannungsteiler R3/R4 derart angeschlossen, daß der Analogeingang der Empfangseinrichtung und deren Signal weiterverarbeitender Komparator K der Betätigungsvorrichtung CO auf eine Bezugsspannung von etwa 2,5 Volt, d.h. auf die Mitte des Analog/Digital-Wandelbereichs gelegt ist. Durch den Spannungsteiler R3/R4 in Verbindung mit einem zwischen diesem und dem Emitter des Empfängers E vorgesehenen Kondensator C wird ein Hochpaßfilter derart gebildet, daß ein störender Gleichlichtanteil der z.B. von einem Umgebungslicht einer Dunstabzugshaube oberhalb der Touchmulde einer Kochstellensteuerung stammt, unterdrückt wird. Die vom Sender S stammenden Lichtimpulse, die über Reflexion an den Empfänger E gelangen, werden in diesem Hochpaß durchgelassen und stehen dem Komparator K der Betätigungseinrichtung CO zur weiteren Auswertung im vorgenannten Sinne zur Verfügung.

Die Empfindlichkeit der Empfangseinrichtung gemäß FIG 4 ist mit dem veränderlichen Widerstand R5 zweckmäßigerweise so einzustellen, daß das Streulichtsignal RE2 bzw.S2 einerseits eine ausreichende Amplitude aufweist, jedoch bei Tastenbetätigung und damit durch den Empfänger E empfangenen Betätigungssignal RE1+RE2 bzw.S1 keine Übersteuerung erfolgt. Im angeommenen Beispiel liegt das Signalverhältnis von S1 zu S2, d.h. von betätigtem Tastenelement im Vergleich zum unbetätigten Tastenelement, etwa bei einem Faktor 3.

FIG 5 zeigt die Toleranzstreubereiche jeweils für die EIN-Signalpegel bzw. die dazu im Abstand a1-a6 angenommenen AUS-Signalpegel in Form von analogen Spannungsamplituden der pulsweisen Signale bei Betätigung bzw. Nichtbetätigung von sechs Tastenelementen T1-T6 einer Kochstellensteuerung.

Es dürfte ersichtlich sein, daß bei der erfindungsgemäßen Betätigungsvorrichtung eine eindeutige Tastenerkennung unter Berücksichtigung von Bauteiltoleranzen, Einbautoleranzen sowie Alterungs- und Temperatureinflüssen ohne Notwendigkeit einer zunächst einzustellenden und dann nachzuführenden Schaltschwelle lediglich aus dem jeweiligen Verhältnis aus innerer Strahlreflexion und äußerer Nutzreflexion bei Betätigung des Tastenelementes gewährleistet werden kann.

## Patentansprüche

1. Betätigungsvorrichtung mit zumindest einem optoelektronischen Tastenelement (T1-T6), insbesondere mit einer berührungsempfindlichen Infrarot-Reflexlichtschranke, mit folgenden Merkmalen:
Die Betätigungsvorrichtung (CO) steht in Empfangsverbindung zu einem von einem Reflexkörper (RE) bei betätigtem Tastenelement (T1-T6) reflektierten Betätigungssignal(RE1+RE2) mit einem EIN-Signalpegel (S1);
die Betätigungsvorrichtung (CO) steht in Empfangsverbindung zu einem von dem Reflexkörper (RE) bei unbetätigtem Tastenelement (T1-T6) reflektierten Streulichtsignal (RE2) mit einem zweiten, von dem EIN-Signalpegel (S1) unterschiedlichen, insbesondere pegelniedrigeren (a1-a6), AUS-Signalpegel (S2);
die Betätigungsvorrichtung (CO) steht in EIN/AUS-Schaltabhängigkeit von einer von Null unterschiedlichen Mindestgröße des jeweiligen Verhältnisses zwischen dem EIN-Signalpegel (S1) und dem AUS-Signalpegel (S2).

2. Betätigungsvorrichtung nach dem vorhergehenden Anspruch mit einem Komparator (K), der als Meßwertumwandler zur Abgabe eines entsprechenden digitalen EIN/AUS-Signals bei eingangsseitigem analogen Betätigungssignale (RE1+RE2) bzw. bei eingangsseitigem analogen Streulichtsignal (RE2) ausgebildet ist.

3. Betätigungsvorrichtung nach zumindest einem der vorhergehenden Ansprüche mit einem pulsförmigen Betätigungssignal (RE1+RE2).

4. Betätigungsvorrichtung nach dem vorhergehenden Anspruch mit einem von einem Gleichlichtanteil durch entsprechende Ausfilterung freien Signalpegeln.

5. Betätigungsvorrichtung nach zumindest einem der vorhergehenden Ansprüche mit mehreren Tastenelementen (T1-T6) mit jeweils individuellen Betätigungssignalen (RE1+RE2) bzw. Streulichtsignalen (RE2).

6. Betätigungsvorrichtung nach zumindest einem der vorhergehenden Ansprüche mit einem sukzessiv mit den Betätigungssignalen (RE1+RE2) bzw. Streulichtsignalen (RE2) je eines von mehreren Tastenlementen (T1-T6) verbundenen Komparator (K) mit Betätigungsvorrichtung (CO).

7. Betätigungsvorrichtung nach zumindest einem der vorhergehenden Ansprüche mit von zumindest einem Tastenelement (T1-T6) einer Kochstellensteuerung eines Herdes, insbesondere von zumindest einem Tastenelement (T1-T6) mit je einer berührungsempfindlichen Infrarot-Reflexlichtschranke (E,S,RE), abgegebenem Betätigungssignal (RE1+RE2) bzw. Streulichtsignal (RE2).
